Europäisches Patentamt

European Patent Office

Office européen des brevets

(11) Publication number: **0 148 786**
**B1**

## EUROPEAN PATENT SPECIFICATION

(45) Date of publication of patent specification: **26.10.88**

(51) Int. Cl.⁴: **H 01 L 27/14**

(21) Application number: **85300171.7**

(22) Date of filing: **10.01.85**

(54) Method of driving a CCD image sensor.

(30) Priority: **10.01.84 JP 3792/84**

(43) Date of publication of application:
**17.07.85 Bulletin 85/29**

(45) Publication of the grant of the patent:
**26.10.88 Bulletin 88/43**

(84) Designated Contracting States:
**DE FR GB**

(56) References cited:
**EP-A-0 088 134**
**EP-A-0 100 199**
**GB-A-2 103 875**

(73) Proprietor: **SHARP KABUSHIKI KAISHA**
**22-22 Nagaike-cho Abeno-ku**
**Osaka 545 (JP)**

(72) Inventor: **Miyatake, Shigehiro**
**12-1-606 Dogashiba 2-chome**
**Tennoji-ku Osaka-shi Osaka-fu (JP)**

(74) Representative: **Wright, Peter David John et al**
**R.G.C. Jenkins & Co. 26 Caxton Street**
**London SW1H 0RJ (GB)**

Courier Press, Leamington Spa, England.

## Description

The present invention relates to a CCD (Charge Coupled Device) image sensor including PN junction photosensor elements and, more particularly, to a novel drive system for ensuring electrical isolation between the PN junction photosensor elements.

Recently, solid state image sensors have been developed for use in a color video camera. The solid state image sensors can be classified into an XY address image sensor type and a CCD image sensor type. The CCD image sensor has an advantage in the S/N ratio (signal to noise ratio) because the output capacity of the CCD image sensor is substantially small. Especially, an interline transfer CCD image sensor including PN junction photodiodes shows a high sensitivity to blue light, and shows a high resolution in combination with a mosaic color filter.

Normally, the CCD has a simple structure. However, various requirements in the function and the characteristic have made the structure complicated. The complicated structure requires increased number of masks and, therefore, the characteristics of the CCD image sensor have become variable.

In order to simplify the structure of the CCD image sensor including photodiodes, the present inventor has developed a novel structure, wherein channel stoppers are not required to electrically isolate photodiodes. An example of this structure is disclosed in our copending European Patent application EP—A—0100199, "Structure and Driving Method of Interline Transfer CCD Image Sensors", which is prior art only under the terms of Article 54(3) EPC. Since the channel stoppers are not required between the photodiodes, the mask alignment operation is simplified. Thus, the characteristics of the CCD image sensor become constant.

However, the drive method disclosed in the above-mentioned application is the frame storage type. Therefore, there is a possibility that a residual image is formed when objects move fast.

According to the present invention there is provided a method of driving a CCD image sensor, which sensor comprises a plurality of PN junction photodiodes (3) formed in a substrate and aligned in a matrix fashion and a plurality of CCD shift registers formed in said substrate, each CCD shift register being associated with a plurality of the said photodiodes (3), the said CCD shift registers having lower electrode means (7, 9) extending over the CCD channels (2) of the shift registers and over regions between adjacent photodiodes (3) and upper electrode means (8, 10) overlapping in part the lower electrode means (7, 9) and extending over the CCD channels (2) of the shift registers and over regions between adjacent photodiodes (3) so that adjacent photodiodes (3) are electrically isolated from one another without using channel stoppers between them by applying suitable signals to said upper and lower electrode means (7, 8, 9, 10), the method comprising applying to both the upper and the lower electrode means (7, 8, 9, 10) clock signals ($\emptyset1$, $\emptyset2$, $\emptyset3$, $\emptyset4$) having two levels ($V_I$, $V_L$) in order to shift the charges along the shift registers while maintaining electrical isolation between adjacent photodiodes (3), and applying to said lower electrode means (7, 9) a clock pulse at a third level ($V_H$) in order to transfer charge stored by a photodiode to said associated CCD shift register.

The present invention will be better understood from the detailed description given hereinbelow and the accompanying drawings which are given by way of illustration only, and thus are not limitative of the present invention and wherein:

Figure 1 is a plan view of a CCD image sensor related to the present invention;

Figure 2 is a sectional view taken along line II—II of Figure 1;

Figure 3 is a sectional view taken along line III—III of Figure 1;

Figure 4 is a waveform chart showing clock pulses which are applied to register electrodes in a conventional drive system;

Figure 5 is a waveform chart showing modified clock pulses considered by the present inventor;

Figure 6 is a schematic chart showing a charge storage condition when the modified clock pulses of Figure 5 are applied to the CCD image sensor of Figure 1;

Figure 7 is a waveform chart showing clock pulses which are applied to register electrodes in accordance with an embodiment of a drive method of the present invention; and

Figure 8 is a schematic chart showing a charge storage condition when the clock pulses of Figure 7 are applied to the CCD image sensor of Figure 1.

Description of the preferred embodiments

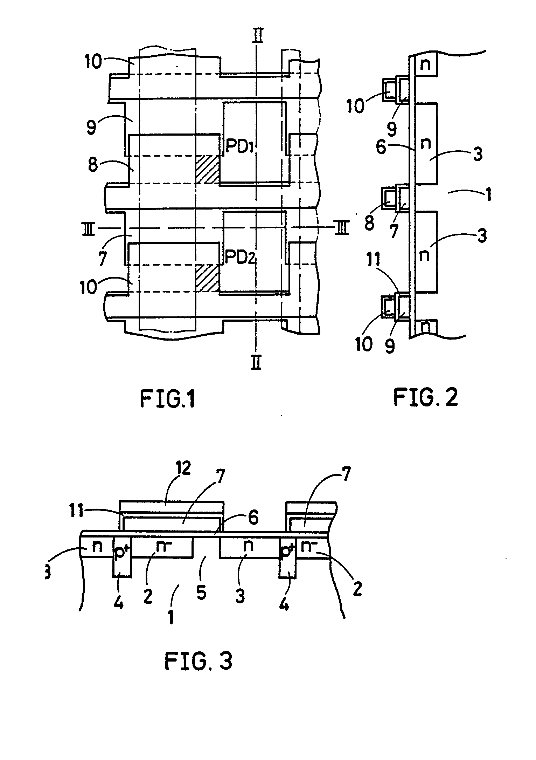

Figures 1, 2 and 3 show a CCD image sensor related to the present invention. The CCD image sensor of Figures 1, 2 and 3 has the same structure as that disclosed in our copending application EP—A—0100199.

Photodiodes 3 are formed in a substrate 1 to align in a matrix fashion. Buried channel CCDs including n layers 2 are formed along the photodiodes 3. Transfer gates 5 are formed between each pair of the corresponding photodiode 3 and the n layer 2. Channel stoppers 4 are formed between the n layer 2 and the adjacent photodiode 3 to achieve the electrical isolation. An insulation film 6 is formed on the substrate 1. Lower polysilicon electrodes 7 and 9 are formed on the insulation film 6 except the portions where the photodiodes 3 or the transfer gates 5 are formed. The portions of the transfer gates 5 are covered by upper polysilicon electrodes 8 and 10. The upper polysilicon electrodes 8 and 10 include portions which overlap the lower polysilicon electrodes 7 and 9 with the intervention of insulator films 11. By properly applying clock pulses to the lower and upper polysilicon electrodes 7, 9, 8 and 10, the charges generated in the photodiodes 3 are transferred to the CCD shift registers, and are transferred in the CCD shift registers.

The main feature of the CCD image sensor of Figures 1, 2 and 3 is that the channel stoppers are not required between the n layers 3 which form the photodiodes as shown in Figure 2. The channel stoppers 4 are required only to isolate the n layers 3 of the photodiodes from the n layers 2 of the adjacent CCD vertical shift register. As discussed in our copending application EP—A—0100199, the mask fitting is simplified. The n layers 3 of the photodiodes are self-aligned with respect to the gate electrodes using the upper and lower polysilicon layers 7, 8, 9 and 10 as a mask.

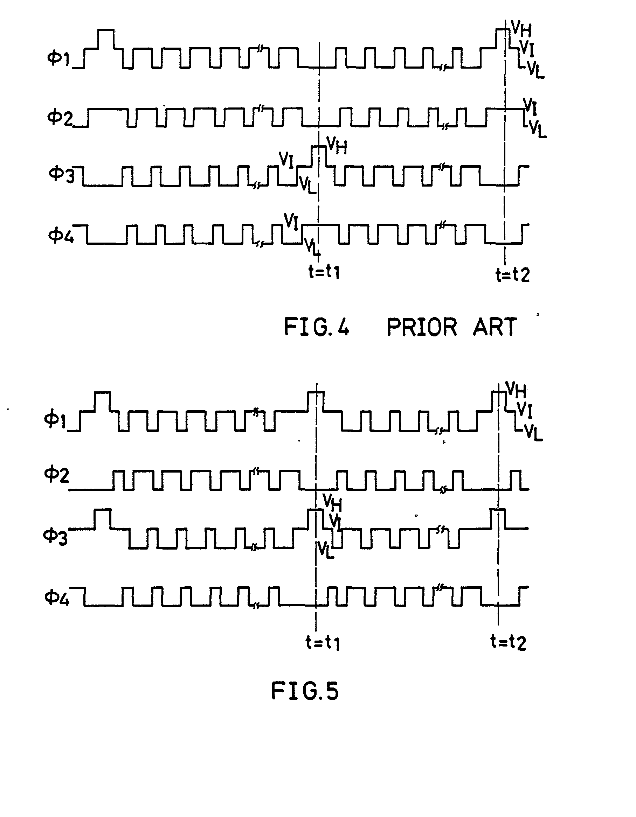

Figure 4 shows clock pulses $\phi_1$, $\phi_2$, $\phi_3$ and $\phi_4$ which are applied to the polysilicon electrodes 10, 7, 8 and 9, respectively, in the drive system disclosed in the copending application EP—A—0100199. The clock pulses $\phi_2$ and $\phi_4$ applied to the lower polysilicon electrodes 7 and 9 take two levels $V_L$ and $V_I$. The clock pulses $\phi_1$ and $\phi_3$ applied to the upper polysilicon electrodes 10 and 8 take three levels $V_L$, $V_I$ and $V_H$. At a time when the clock pulse $\phi_1$ or $\phi_3$ bears the level $V_H$, the signal charges stored in the photodiode and transferred to the CCD vertical shift register via the transfer gate 5 (hatched portion in Figure 1) formed under the electrode 10 or 8. Although the channel stoppers are not formed between the photodiodes, the signal charges are not mixed because the clock pulses $\phi_2$ and $\phi_4$ applied to the lower polysilicon electrodes 7 and 9 bear the levels $V_L$ and $V_I$, respectively. While the clock pulses $\phi_1$ and $\phi_3$ change between the levels $V_L$ and $V_I$, the signal charges are transferred upward in the CCD vertical shift register in Figure 1.

As already discussed above, the signal charges stored in the photodiode $PD_1$ are transferred to the CCD vertical shift register at a time $t=t_1$ at which the clock pulse $\phi_3$ bears the level $V_H$. The signal charges stored in the photodiode $PD_2$ are transferred to the CCD vertical shift register at a time $t=t_2$ where the clock pulse $\phi_1$ bears the level $V_H$. In this way, the read out operation is correlated with the interlace of the television standard. The above-mentioned read out operation is referred to as the frame storage type wherein the pair of photodiodes are alternatively read out in each field. Each photodiode accumulates the signal charges for one frame period (1/30 seconds) and, therefore, a residual image is formed when the object moves fast.

There is another type of read out operation which is referred to as the field storage type, wherein each photodiode accumulates the signal charges for one field period (1/60 seconds), and the signal charges stored in two photodiodes are mixed with each other. The pair of the photodiodes is changed between the odd field and the even field so as to correlate with the interlace. The vertical resolution is slightly reduced, but the occurrence of the residual image is minimized.

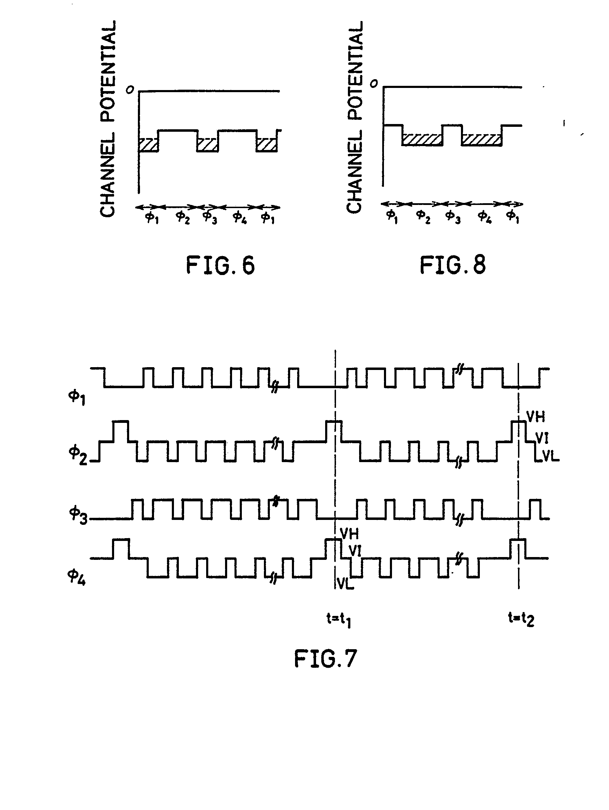

Figure 5 shows one approach to conduct the field storage drive in the CCD image sensor of Figures 1, 2 and 3. At the timing $t==t_1$ and $t=t_2$, both the clock pulses $\phi_1$ and $\phi_3$ take the level $V_H$ to transfer the signal charges stored in the photodiodes to the CCD vertical shift register. However, the drive method of Figure 5 has the following problems. The clock pulses $\phi_1$ and $\phi_3$ are applied to the electrodes 10 and 8, respectively, which overlap the lower polysilicon electrodes 7 and 9. Thus, the effective portions are only clearances where the lower polysilicon electrodes 7 and 9 are not formed. Therefore, the signal charges are transferred to a narrow portion in the CCD vertical shift register as shown in Figure 6. The transferred charges may overflow, and the maximum signal charges are limited by this region.

Figure 7 shows clock pulses $\phi_1$, $\phi_2$, $\phi_3$ and $\phi_4$ which are applied to the electrodes 10, 7, 8 and 9 in an embodiment of a drive method of the present invention. At a timing where the signal charges generated in the photodiodes 3 are transferred to the CCD vertical shift registers, the clock pulses $\phi_2$ and $\phi_4$ applied to the lower polysilicon electrodes 7 and 9 change among three levels $V_L$, $V_I$ and $V_H$, und the clock pulses $\phi_1$ and $\phi_3$ applied to the upper polysilicon electrodes 10 and 8 change between two levels $V_L$ and $V_I$. That is, the clock pulse level inversely corresponds to that of the drive method described with reference to Figure 5.

More specifically, at a time $t=t_1$, both the clock pulses $\phi_2$ and $\phi_4$, which are applied to the lower polysilicon electrodes 7 and 9, respectively, take the level $V_H$ to transfer the signal charges stored in the photodiodes 3 to the CCD vertical shift registers. The clock pulses $\phi_2$ and $\phi_4$ are applied to the lower polysilicon electrodes 7 and 9 which have the function to isolate the photodiodes 3. However, the signal charges stored in the photodiodes 3 are not mixed with each other because the potential applied to the portion provided between the photodiodes 3 is lower than the potential applied to the portion provided between the photodiode 3 and the CCD vertical shift register due to the two-dimentional effect.

Figure 8 shows the charge storage condition in the vertical shift register. The charges are stored in the wide areas covered by the lower polysilicon electrodes 7 and 9 and, therefore, the signal charges are not restricted by these areas.

**Claims**

1. A method of driving a CCD image sensor, which sensor comprises a plurality of PN junction photodiodes (3) formed in a substrate and aligned in a matrix fashion and a plurality of CCD shift registers formed in said substrate, each CCD shift register being associated with a plurality of the said photodiodes (3), the said CCD shift registers having lower electrode means (7, 9) extending over the CCD channels (2) of the shift registers and over regions between adjacent photodiodes (3) and upper electrode means (8, 10) overlapping in part the lower electrode means (7, 9) and extending over the CCD channels (2) of the shift registers and over regions between adjacent photodiodes (3) so that adjacent photodiodes (3) are electrically isolated from one another without using channel stoppers between them by applying suitable signals to said upper and lower electrode means (7, 8, 9, 10), the method comprising applying to both the upper and the lower electrode means (7, 8, 9, 10) clock signals (Ø1, Ø2, Ø3, Ø4) having two levels ($V_I$, $V_L$) in order to shift the charges along the shift registers while maintaining electrical isolation between adjacent photodiodes (3), and applying to said lower electrode means (7, 9) a clock pulse at a third level ($V_H$) in order to tranfer charge stored by a photodiode to said associated CCD shift register.

2. A method according to claim 1, in which the portions of the CCD channels (2) of the shift registers controlled by the said lower electrode means (7, 9) and which accept charges from said associated photodiodes (3) during the said transfer are wider than the adjacent portions of the CCD channels (2) of the shift registers controlled by the said upper electrode means (8, 10) which could accept a charge from said photodiodes (3) if the said pulse at a third level ($V_H$) was applied to the upper electrode means (8, 10).

**Patentansprüche**

1. Verfahren zum Betreiben eines CCD-Bildsensors mit einer Mehrzahl von Fotodioden (3) mit PN-Übergängen, die in einem Substrat ausgebildet und matrixförmig angeordnet sind, und mit einer Mehrzahl von CCD-Schieberegistern, die im Substrat ausgebildet und jeweils einer Mehrzahl der Fotodioden (3) zugeordnet sind, welche CCD-Schieberegister untere Elektroden (7, 9), die sich über die CCD-Kanäle (2) der Schieberegister und über Bereiche zwischen benachbarten Fotodioden (3) erstrecken, sowie obere Elektroden (8, 10) aufweisen, die die unteren Elektroden (7, 8) teilweise überlappen und sich über die CCD-Kanäle (2) der Schieberregister und über Bereiche zwischen benachbarten Fotodioden (3) so erstrecken, daß benachbarte Fotodioden (3) elektrisch voneinander ohne dazwischen liegende Kanalbegrenzer dadurch isoliert sind, daß geeignete Signale an die oberen und unteren Elektroden (7, 8, 9, 10) angelegt werden, bei welchem Verfahren weiterhin an die oberen und unteren Elektroden (7, 8, 9, 10), Taktsignale (Ø1, Ø2, Ø3, Ø4) mit zwei Pegeln ($V_I$, $V_L$) angelegt werden, um elektrische Ladungen entlang der Schieberegister zu verschieben, während die elektrische Isolierung zwischen benachbarten Fotodioden (3) aufrechterhalten wird, und bei dem an die unteren Elektroden (7, 9) ein Takipuls mit einem dritten Pegel ($V_H$) angelegt wird, um durch eine Fotodiode gespeicherte Ladung in das zugehörige CCD-Schieberegister zu übertragen.

2. Verfahren nach Anspruch 1, bei dem diejenigen Abschnitte der CCD-Kanäle (2) der Schieberegister, die durch die unteren Elektroden (7, 9) gesteuert werden und die Ladungen aus den zugehörigen Fotodioden (3) während der genannten Übertragung erhalten, breiter sind als die benachbarten Bereiche der CCD-Kanäle (2) der Schieberegister, die durch die oberen Elektroden (8, 10) gesteuert werden, die Ladung von den Fotodioden (3) aufnehmen können, wenn der Puls mit drittem Pegel ($V_H$) an die oberen Elektroden (8, 10) gelegt wurde.

**Revendications**

1. Procédé pour commander un capteur d'images CCD, qui comprend une pluralité de photodiodes (3) à jonction PN, formées dans un substrat et alignées à la manière d'une matrice, et une pluralité de registres à décalage CCD formés dans ledit substrat et dont chacun est associé à une pluralité desdites photodiodes (3), ledits registres à décalage CCD possédant des moyens en forme d'électrodes inférieures (7, 9), qui s'étendent au-dessus des canaux CCD (2) des registres à décalage et au-dessus de régions situées entre les photodiodes voisines (3), et des moyens en forme d'électrodes supéreures (8, 10) qui chevauchent une partie des moyens en forme d'électrodes inférieures (7, 9) et s'étendent pardessus les canaux CCD (2) des registres à décalage et pardessus des régions situées entre des photodiodes voisines (3) de sorte que les photodiodes voisines (3) sont isolées électriquement les unes des autres sans l'utilisation de dispositifs d'arrêt de canal entre elles, au moyen de l'application de signaux appropriés auxdits moyens en forme d'électrodes supérieures et inférieures (7, 8, 9, 10), le procédé incluant l'application, à la fois aux moyens en forme d'électrodes supérieures et aux moyens en forme d'électrodes inférieures (7, 8, 9, 10), de signaux d'horloge ($\phi_1$, $\phi_2$, $\phi_3$, $\phi_4$) possédant deux niveaux ($V_I$, $V_L$) de manière à transférer les charges le long des registres à décalage tout en maintenant l'isolation électrique entre des photodiodes voisines (3), et l'application, auxdits moyens en forme d'électrodes inférieures (7, 9), d'une impulsion d'horloge située à un troisième niveau ($V_H$) de manière à transférer la charge stockée par une photodiode audit registre à décalage CCD associé.

2. Procédé selon la revendication 1, dans lequel les parties des canaux CCD (2) des registres à décalage, qui sont commandées par lesdits moyens en forme d'électrodes inférieures (7, 9) et acceptent des charges en provenance desdites photodiodes associées (3) pendant ledit transfert, sont plus larges que les parties voisines des canaux CCD (2) des registres à décalage, qui sont commandées par lesdits moyens en forme d'électrodes supérieures (8, 10) et accepteraient une charge provenant desdites photodiodes (3) si ladite impulsion située à un troisième niveau ($V_H$) était appliquée aux moyens en forme d'électrodes supérieures (8, 10).

FIG.1

FIG. 2

FIG. 3

0 148 786

FIG. 4    PRIOR ART

FIG.5

2

FIG. 6

FIG. 8

FIG. 7